# DEMANDE DE BREVET EUROPEEN

(11) **EP 4 195 050 A1**
(43) Date de publication de la demande: **14.06.2023**
(21) Numéro de dépôt: 22211865.5
(22) Date de dépôt: 07.12.2022
(51) Int. Cl.: G06F 11/10, G06F 11/14, G11C 13/00

(54) **PROCEDE ET DISPOSITIF DE CORRECTION D'ERREURS DANS LES MEMOIRES RESISTIVES**

(30) Priorité: 10.12.2021 FR 2113306
(71) Demandeur: COMMISSARIAT À L'ÉNERGIE ATOMIQUE ET AUX ÉNERGIES ALTERNATIVES, 75015 Paris (FR)
(72) Inventeur: GHERMAN, Valentin, 38054 Grenoble Cedex 09 (FR)
(74) Mandataire: Atout PI Laplace

(57) **Abrégé**

L'invention concerne une solution pour améliorer la correction d'erreurs dans une mémoire résistive 2T2R protégée par un code correcteur d'erreur. De manière générale, le principe de l'invention repose sur un procédé qui permet par des lectures 1T1R d'identifier dans un mot de code stocké en mémoire, des bits susceptibles d'être erronés dits « erasures », puis d'inverser ces bits dans le mot de code stocké afin de générer un nouveau mot corrigé par l'ECC.

## Description

### Domaine technique

L'invention se situe dans le domaine des mémoires résistives ou RRAM pour « Résistive Random Access Memory » selon la terminologie anglo-saxonne, et concerne plus particulièrement un procédé et un dispositif permettant d'améliorer la correction d'erreurs dans des mémoires résistives de type 2T2R.

### Etat de la technique

Les mémoires résistives sont des mémoires non-volatiles présentant une vitesse de fonctionnement élevée, une faible consommation d'énergie électrique et une grande durée de vie. Pour ces raisons, les mémoires résistives sont des candidates prometteuses pour remplacer à la fois les mémoires vives et les mémoires non-volatiles actuelles telles que les mémoires de type flash.

Il existe plusieurs technologies de mémoires résistives. On peut notamment citer les mémoires résistives à pont conducteur, également appelées CBRAM (pour « Conductive-Bridging Random-Access Memory » selon la terminologie anglo-saxonne), ou les mémoires résistives à base d'oxyde, également appelées OxRAM (pour « Oxide-based Random-Access Memory » selon la terminologie anglo-saxonne), ou encore les mémoires à changement de phase, également appelées PCM (pour « Phase Change Memory » selon la terminologie anglo-saxonne).

Une mémoire résistive est composée d'une multitude de cellules mémoires résistives agencées en lignes et colonnes de manière à former une matrice. Une cellule mémoire RRAM est dotée d'au moins un élément résistif dont on peut modifier la conductance.

Typiquement, une cellule mémoire RRAM dans son état initial a une structure métallique isolante et est dans un état de haute résistance (HRS) (pour « High Résistance State » selon la terminologie anglo-saxonne). Avant leur utilisation, certains types de mémoire résistive, telles que les mémoires OxRAM ou CBRAM, nécessitent une activation électrique. L'application d'une impulsion haute tension externe à travers la cellule RRAM permet la formation de chemins conducteurs dans la couche de commutation et la cellule RRAM est commutée dans un état à faible résistance (LRS) (pour « Low Resistance State » selon la terminologie anglo-saxonne). Le processus général de cette rupture de la structure métallique isolante de la cellule est généralement appelé «électroformage» (ou « forming » selon la terminologie anglo-saxonne).

Le matériau diélectrique qui est disposé entre les deux électrodes conductrices de la cellule va permettre à la cellule de basculer de manière réversible entre deux états de résistance HRS et LRS, chacun des états permettant de stocker un bit d'information dans la cellule mémoire.

Pour programmer une cellule mémoire, une tension de programmation est appliquée entre les électrodes de la cellule mémoire. Il peut s'agir d'une tension d'écriture pour écrire la cellule mémoire, c'est-à-dire la placer dans l'état LRS, ou d'une tension d'effacement pour effacer la cellule mémoire, c'est-à-dire la placer dans l'état HRS. Cependant, après une opération de programmation, il peut arriver que la cellule mémoire ne passe pas dans l'état de résistance souhaité. Pour cette raison, il est généralement effectué une vérification que la cellule mémoire est correctement programmée en comparant sa valeur de résistance R à une valeur seuil de résistance prédéfinie R_{REF}.

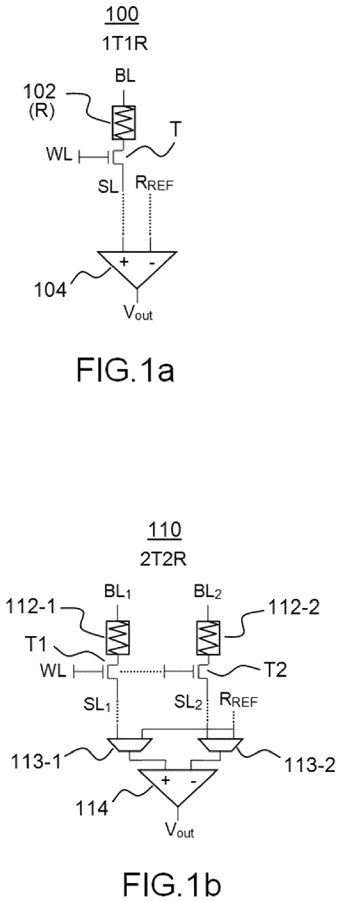

La figure 1a illustre de manière simplifiée une cellule mémoire résistive élémentaire, constituée généralement d'un transistor (T) et d'un composant résistif (R) ou résister (102), où un bit d'information est encodé par la valeur de la résistance électrique du résister. Pour ces cellules élémentaires, un '0' logique peut par exemple être encodé en programmant le résister dans un état LRS, et un '1' logique peut alors être encodé en programmant le résister dans un état HRS, et l'on parle alors d'encodage en mode 1T1R.

Cependant, l'écart entre la plus faible valeur correspondant à un niveau HRS et la plus haute valeur correspondant au niveau LRS, également appelé « fenêtre mémoire », est souvent faible. Dès lors, on utilise couramment un « encodage différentiel » ou encodage 2T2R pour coder une valeur binaire à mémoriser. Un bit d'information peut alors être encodé dans une cellule mémoire dite 2T2R telle qu'illustrée de manière simplifiée sur la figure 1b, et composée de deux cellules élémentaires 1T1R, comprenant 2 transistors (T1, T2) et 2 résistors (112-1, 112-2).

Comme chacun des états HRS et LRS peut être associé à une valeur logique, i.e. 1 ou 0, on peut considérer que dans une cellule 2T2R un des deux éléments résistifs encode le bit à programmer en version non-inversée tandis que l'autre élément résistif encode le même bit en version inversée. Par exemple, un '1' logique est encodé en programmant le résistor de la première cellule 1T1R dans un état HRS et le résistor de la deuxième cellule 1T1R dans un état LRS, et un '0' logique est encodé en programmant le résistor de la première cellule 1T1R dans un état LRS et le résistor de la deuxième cellule dans un état HRS.

Ainsi, en encodage différentiel, chaque bit d'information est encodé dans une cellule élémentaire 2T2R formée de deux éléments résistifs écrits en opposition d'état, c'est-à-dire un des éléments résistifs avec un niveau HRS et l'autre un niveau LRS. Les niveaux respectifs de résistance des deux éléments résistifs sont déterminés toujours dans le même ordre entre les deux éléments, et définissent alors si l'on est en présence d'un '0' ou d'un '1' logique, suivant que cela correspond à l'état HRS-LRS ou à l'état LRS-HRS.

Lors d'une opération d'écriture dans une cellule mémoire 1T1R ou une cellule mémoire 2T2R, il faut s'assurer que chaque résistance électrique qui doit être programmée à l'état HRS ou l'état LRS est respectivement soit plus grande, soit plus petite qu'une valeur de référence R_{REF}. La comparaison d'une résistance électrique avec la valeur R_{REF} est faite par une opération de lecture au cours de laquelle la résistance programmée est comparée à la valeur R_{REF} à l'aide d'un amplificateur de détection ou SA (pour « Sense Amplifier» selon la terminologie anglo-saxonne) illustré par le composant 104 sur la figure 1a et 114 sur la figure 1b. Par la suite, cette opération de lecture avec comparaison à une valeur de référence est appelée lecture en mode 1T1R ou lecture 1T1R.

Sur la figure 1a, l'amplificateur de détection 104 réagit à la différence de son entrée `SL' (provenant de la cellule 1T1R) et de son entrée 'R_{REF}' (représentative d'une valeur de résistance électrique de référence R_{REF}), pour générer un signal de sortie 'V_{OUT}' qui indique l'état résistif de l'élément mémoire de la cellule et renseigne sur la valeur qui est stockée dans la cellule 1T1R.

Sur la figure 1b, l'amplificateur de détection 114 va réagir à une différence sur ses entrées, pour générer un signal de sortie 'V_{OUT}'. Dans cette implémentation, un multiplexeur (113-1, 113-2) est respectivement couplé à la sortie (SL1, SL2) de chaque cellule 1T1R pour effectuer une lecture 1T1R par comparaison avec la valeur de référence R_{REF}. Lors d'une lecture 2T2R, la sortie de chaque multiplexeur correspond à la valeur de chaque cellule respective, et devient une entrée de l'amplificateur de détection 114. La sortie de l'amplificateur de détection 114 réagit alors à la différence en résistance des deux éléments résistifs de la cellule 2T2R (112-1, 112-2) et renseigne sur la valeur qui est stockée dans la cellule 2T2R sélectionnée.

Toutes les opérations de lecture dans les mémoires 1T1R sont effectuées en mode 1T1R. Pour lire efficacement les données de la cellule RRAM, une petite tension de lecture qui ne perturbe pas l'état courant de la cellule est appliquée pour déterminer dans quel état logique est la cellule.

Dans les mémoires où l'information est encodée en mode 2T2R, les opérations de lecture, hors celle de vérification de la programmation, peuvent être effectuées en mode 2T2R aussi appelé lecture en mode différentiel ou lecture 2T2R. Les valeurs des deux résistances présentes dans chaque cellule mémoire 2T2R qui est adressée, sont comparées entre elles à l'aide d'un amplificateur de détection SA.

L'usage d'une mémoire implique de fréquentes transitions entre un état HRS et un état LRS et réciproquement, et chaque événement de commutation entre ces états résistifs peut introduire des dommages, les valeurs des résistances programmées pouvant changer à cause de phénomènes de relaxation, et entraîner alors une dégradation des performances de la RRAM.

Le temps de rétention de l'information dans une mémoire résistive dépend alors (a) des opérations de lecture, (b) des températures d'utilisation et/ou (c) des champs magnétiques élevés dans le cas des mémoires magnétiques.

De plus, les tensions de commutation sont aussi des paramètres présentant un degré élevé de variation. Les variations de la commutation de résistance comprennent des fluctuations temporelles (cycle à cycle) et des fluctuations spatiales (appareil à appareil).

Par ailleurs, les mémoires résistives présentent également une non-uniformité cellule à cellule qui dégrade également les performances de la mémoire en réduisant la marge de mémoire entre deux états. L'origine de cette variabilité est attribuée aux non-uniformités du processus de fabrication telles que l'épaisseur du film de commutation, les dommages de gravure et la rugosité de surface des électrodes.

Ces variations entrainent que les résistances des mémoires résistive qui sont programmées dans l'état LRS peuvent dériver vers un état HRS, et les résistances qui sont programmées dans l'état HRS peuvent dériver vers un état LRS. Dès lors, ce glissement des valeurs des résistances programmées peut engendrer des erreurs lors des opérations de lecture, et diminuer la performance des mémoires.

Une manière courante d'améliorer la performance des mémoires RRAM est de diminuer leur taux d'erreur. Pour réduire le taux d'erreur des mémoires, une solution couramment utilisée consiste à utiliser un code correcteur d'erreurs ou ECC (pour « Error Correcting Code » selon la terminologie anglo-saxonne) qui encode les données avant leur écriture en mémoire. Lors de l'encodage de données avec un code ECC, des bits de vérification sont ajoutés aux bits de données, les bits de vérification représentant une information redondante calculée à partir des bits de données, qui permet la détection et la correction des erreurs affectant aussi bien les bits de données que les bits de vérification. L'ensemble des bits de données et des bits de vérification forme un mot de code.

La demande de brevet US.2015/212880 A1 de Carissimi Marcella et al. présente une solution de correction d'erreurs par ECC dans une mémoire résistive de type 1T1R.

En présence d'un taux d'erreurs élevé, une solution est d'utiliser des ECCs de plus en plus puissants. Cependant, cela entraine un surcoût en termes de surface de stockage pour les bits de vérification et de surface, de latence et de consommation du décodeur ECC.

Une approche pour éviter l'utilisation d'un ECC puissant, est de réduire le taux d'erreurs primaire, c'est-à-dire le taux d'erreurs en sortie du circuit mémoire qui serait obtenu sans l'utilisation d'un ECC. Pour réduire le taux d'erreurs primaire, une méthode consiste à utiliser des mémoires 2T2R au lieu de mémoires 1T1R. Cependant, il reste des cas où même avec l'utilisation d'une mémoire 2T2R le taux d'erreurs primaire reste élevé.

Aussi, dans ces situations ou encore celles où il faudrait choisir un ECC avec un moindre surcoût et donc une capacité de correction plus faible, une solution connue est d'identifier les cellules qui sont dans un état pouvant être considéré comme faible, c'est-à-dire des cellules susceptibles de délivrer un bit erroné, ces bits étant désignés comme « erasure », puis d'utiliser cette information pour améliorer la correction d'erreurs.

L'article de C.L. Chen et M.Y. Hsiao, "Error-Correcting Codes for semiconductor memory applications: a state of the art review," IBM Journal of Research and Development, volume 28, issue 2, 1984, présente une méthode de détection de cellules mémoires qui sont affectées par des fautes de collage (« stuck-at fault » en anglais). Tout bit lu à partir d'une telle cellule est considéré comme une erasure. Suite à la détection d'un nombre d'erreurs non corrigeables dans un mot mémoire, ce type d'erasure peut être détecté par une opération d'écriture du mot inversé suivie d'une opération de lecture à la même adresse mémoire. Tout bit qui ne change pas de valeur suite à l'écriture du mot inversé est alors considéré comme une erasure. Après la correction d'erreurs améliorée par l'identification d'erasures, le mot corrigé qui est inversé une deuxième fois, est stocké toujours à la même adresse dans la mémoire. Cette méthode ne permet d'identifier que des erasures très particulières, i.e. celles associées à des bits stockés dans des cellules mémoires qui ne fonctionnent pas.

L'article de S. Evain, V. Savin et V. Gherman, "Error Correction Schemes with Erasure Information for Fast Memories," Journal of Electronic Testing: Theory and Applications (JETTA), volume 30, issue 2, d'avril 2014, décrit une méthode et des dispositifs pour des mémoires permettant d'augmenter la capacité de correction d'un ECC en s'appuyant sur l'identification d'erasures. Cette méthode utilise l'identification d'erasures par des opérations de lecture supplémentaires qui comparent une valeur lue à différentes valeurs de référence. Cette méthode requière la modification du circuit mémoire due à la nécessité d'ajouter des multiplexeurs supplémentaires avant chaque amplificateur de détection, dans le but de choisir des valeurs de référence supplémentaires.

Aussi, face à la problématique générale de la dérive des valeurs de résistance dans les cellules mémoires résistives RRAM, et face aux limites des solutions connues basées sur l'utilisation de code correcteur d'erreur, il existe le besoin d'une solution pour diminuer les erreurs de lecture dans les mémoires résistives RRAM, en particulier dans les mémoires RRAM 2T2R.

La présente invention répond à ce besoin.

### Résumé de l'invention

L'invention a pour objet une solution pour améliorer la correction d'erreurs dans les mémoires résistives protégées par un code correction d'erreurs.

De manière générale, le principe de l'invention repose sur un procédé qui permet d'identifier dans un mot de code programmé dans une mémoire résistive 2T2R protégée par un code correcteur d'erreur, des bits susceptibles d'être erronés, appelés bit(s) faible(s) ou « erasure(s) », puis d'inverser ces bits afin de générer un nouveau mot qui peut être corrigé par le décodeur du code correcteur d'erreur.

Avantageusement, le procédé de la présente invention ne nécessite pas de modification de la matrice mémoire. La méthode proposée n'a pas d'impact sur les opérations d'écriture dans les mémoires résistives concernées.

Ainsi l'objet de l'invention est de pallier les inconvénients des solutions connues par une solution qui ne nécessite pas d'opérations impliquant l'utilisation de valeurs de référence supplémentaires.

Pour parvenir au but recherché, il est proposé un procédé de correction d'erreurs d'un mot de code stocké dans une mémoire résistive de type 2T2R, un mot de code étant composé de bits de données et de bits de vérification, la mémoire résistive 2T2R comprenant une matrice de cellules mémoires résistives 2T2R élémentaires où chaque cellule élémentaire comprend deux transistors et deux éléments résistifs pour stocker la valeur non-inversée et la valeur inversée d'un bit, et pour lire les bits stockés en mode différentiel, la lecture en mode différentiel ou lecture 2T2R consistant à comparer l'une par rapport à l'autre, les valeurs du premier et deuxième élément résistif de la cellule élémentaire utilisée pour stocker chaque bit d'un mot à une adresse indiquée, afin de déterminer la valeur lue. Le procédé comprend au moins les étapes consistant à :
- déterminer, après une opération de correction d'erreurs par un code correcteur d'erreur couplé à la mémoire résistive, qu'un mot de code lu en lecture 2T2R contient des erreurs non corrigées qui affectent un nombre de bits supérieur à un seuil prédéfini ;
- effectuer au moins une lecture en mode simple ou lecture 1T1R du mot de code stocké, consistant à comparer à une valeur de référence R_{ERASURE}, la valeur d'un des deux éléments résistifs des cellules élémentaires adressées pour chaque bit du mot de code, afin de déterminer la valeur lue ;
- comparer pour chaque bit du mot de code, la valeur lue par la dite au moins une lecture 1T1R à la valeur lue en lecture 2T2R pour identifier des bits susceptibles d'être erronés, lesdits bits susceptibles d'être erronés étant :
   - des bits pour lesquels la valeur lue en lecture 1T1R est identique à la valeur lue en lecture 2T2R, si ladite au moins une lecture 1T1R se fait sur les éléments résistifs de la cellule élémentaire encodant les valeurs inversées des bits ; ou
   - des bits pour lesquels la valeur lue en lecture 1T1R est différente de la valeur lue en lecture 2T2R, si ladite au moins une lecture 1T1R se fait sur les éléments résistifs de la cellule élémentaire encodant les valeurs non-inversées des bits ;
- inverser, dans ledit mot de code lu en lecture 2T2R, lesdits bits identifiés comme susceptibles d'être erronés ; et
- corriger avec le code correcteur d'erreur ledit mot de code obtenu après l'étape d'inversion.

Selon des modes de réalisation alternatifs ou combinés :
- L'étape de déterminer qu'un mot de code contient des erreurs non corrigées qui affecte un nombre de bits supérieur à un seuil prédéfini, consiste à déterminer que ledit nombre de bits affectés est égal au nombre maximum de bits erronés que le décodeur du code correcteur d'erreur peut détecter dans un mot de code.
- Les étapes de lecture 1T1R et de comparaison de valeur lue consistent à : effectuer une première lecture 1T1R de chaque premier élément résistif des cellules élémentaires adressées pour chaque bit du mot de code, afin de déterminer une première valeur lue ; effectuer une deuxième lecture 1T1R de chaque deuxième élément résistif des cellules élémentaires adressées pour chaque bit du mot de code, afin de déterminer une deuxième valeur lue ; et comparer la première valeur lue en mode 1T1R à la deuxième valeur lue en mode 1T1R, pour identifier des bits susceptibles d'être erronés comme étant des bits pour lesquels la première valeur lue et la deuxième valeur lue sont identiques.
- Le procédé comprend avant l'étape de décodage, une étape consistant à stocker la valeur de chaque bit du mot de code lu en mode 2T2R dans un registre couplé à la mémoire résistive.
- L'étape de corriger le mot de code obtenu après inversion, comprend des étapes consistant à :
   - stocker la valeur de chaque bit dudit mot de code obtenu après inversion dans un registre couplé à la mémoire résistive ;
   - corriger par le code correcteur d'erreur ledit mot de code stocké ; et
   - stocker le mot de code corrigé dans le registre de sortie du décodeur du code correcteur d'erreur.
- L'étape de comparaison comprend des étapes consistant à :
   - stocker la valeur de chaque bit lu en mode 1T1R dans un registre couplé à la mémoire résistive ; et
   - comparer la valeur de chaque bit stocké à la valeur de chaque bit du mot de code lu en mode 2T2R.
- L'étape d'effectuer au moins une lecture en mode 1T1R consiste à comparer la valeur lue à une valeur de référence R_{ERASURE} qui peut être identique à la valeur de référence utilisée pour programmer les cellules élémentaires de la mémoire résistive.

L'invention a aussi pour objet un programme d'ordinateur comportant des instructions de code pour l'exécution des étapes du procédé de correction d'erreurs, lorsque ledit programme est exécuté par un processeur.

L'invention couvre aussi un dispositif de correction d'erreurs comprenant des moyens permettant de mettre en oeuvre les étapes du procédé de correction d'erreurs d'un mot de code stocké dans une mémoire résistive de type 2T2R, tel que revendiqué.

Dans un mode de réalisation, le code correcteur d'erreur est un circuit de type SEC-DED.

Dans une variante de réalisation, le code correcteur d'erreur est un circuit de type DEC-TED.

Un autre objet de l'invention couvre tout système électronique de type FPGA ou ASIC comprenant un dispositif de correction d'erreurs tel que revendiqué.

### Description des figures

D'autres caractéristiques, détails et avantages de l'invention ressortiront à la lecture de la description faite en référence aux dessins annexés donnés à titre d'exemple et qui représentent, respectivement :
La figure 1a et la figure 1b illustrent respectivement des exemples d'implémentation d'une cellule mémoire 1T1R et d'une cellule mémoire 2T2R ;
La figure 2 illustre les étapes d'un procédé conventionnel de lecture dans une mémoire 2T2R protégée par un ECC ;
La figure 3 illustre un système général permettant de mettre en oeuvre les étapes d'un procédé de lecture conventionnelle dans une mémoire 2T2R protégée par un ECC ;
La figure 4 illustre la dérive des valeurs des résistances d'une cellule mémoire résistive 2T2R ;
La figure 5 illustre les étapes du procédé de correction d'erreurs de l'invention dans un mode de réalisation ;
La figure 6 montre un exemple d'un mot de code corrigé par le procédé de l'invention ;
La figure 7 illustre un mode de réalisation d'un circuit permettant de réaliser une inversion de bits identifiés comme erasures ;
La figure 8 est un chronogramme de différents signaux opérant sur le circuit de la figure 7 ; et
La figure 9 illustre un autre mode de réalisation d'un circuit permettant de réaliser une inversion de bits identifiés comme erasures.

### Description détaillée de l'invention

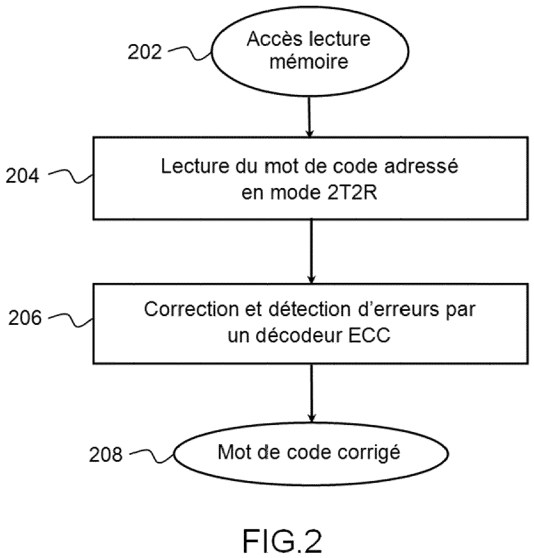

La figure 2 illustre les étapes d'un procédé conventionnel de lecture dans une mémoire 2T2R protégée par un code correcteur d'erreur (ECC). Le procédé 200 débute par une étape 202 de réception d'une commande de lecture pour accéder à un mot de code stocké à une adresse donnée, le mot de code étant composé de bits de données et de bits de vérification

Après que le mot de code soit lu 204 en mode 2T2R à l'adresse indiquée par la commande de lecture, dans une étape suivante 206, le décodeur de l'ECC est utilisé de manière conventionnelle (i.e. le décodeur cherche la localisation d'erreurs mais n'utilise pas d'informations sur d'éventuelles erasures) pour détecter et corriger des bits erronés dans le mot de code lu.

Selon le type d'ECC et le nombre d'erreurs, tous les bits erronés peuvent ou non être corrigés, et suite à l'étape 206 de décodage ECC, un mot de code corrigé est disponible, et dont les bits des données peuvent être mis à la disposition du système électronique qui a lancé la commande de lecture.

Sans limitation, un ECC connu est le circuit SEC-DED (acronyme de l'anglicisme « Single Error Correction-Double Error Détection ») qui permet la correction des erreurs sur un seul bit (SEC) et la détection des erreurs sur deux bits (DED). L'homme du métier pourra se reporter aux nombreux documents disponibles de la littérature qui décrivent différents types de circuits code correcteur d'erreurs et mécanismes de correction et détection d'erreurs par un ECC.

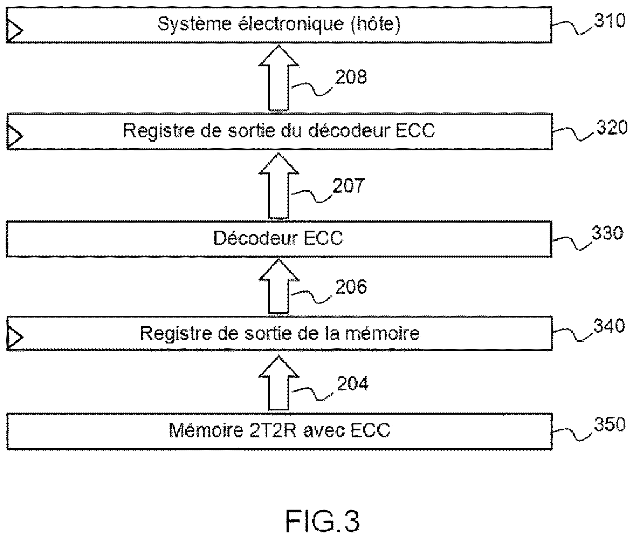

La figure 3 illustre un système général permettant de mettre en oeuvre les étapes d'un procédé de lecture conventionnelle dans une mémoire 2T2R protégée par un ECC, tel que le procédé décrit en référence à la figure 2.

Les commandes de lecture mémoire sont initialisées depuis un système électronique hôte 310. Le système électronique 310 peut être un circuit à base de processeurs, de multiprocesseurs, de FPGA (acronyme de « Field-Programmable Gate Array » en anglais) ou d'ASIC (acronyme de « Application Spécifie Integrated Circuit » en anglais).

Dans un mode de réalisation, le système électronique 310 peut être un contrôleur mémoire implémenté dans un système de stockage.

Les bits du mode de code lu dans la mémoire 2T2R 350 sont stockés dans un registre de sortie 340 de la mémoire. La mémoire résistive 2T2R 350 peut être organisée comme une matrice de cellules mémoires résistives 2T2R élémentaires où chaque cellule élémentaire comprend deux transistors et deux éléments résistifs pour encoder la valeur non-inversée et la valeur inversée d'un bit, en programmant une des deux résistances en LRS et l'autre en HRS, et pour faire une lecture 2T2R des bits encodés.

Les bits lus sont transférés de la mémoire vers un décodeur ECC 330 afin de corriger les éventuelles erreurs survenues lors de leur stockage et/ou de leur lecture. Suite à l'opération de décodage ECC, les bits de données du mot de code corrigé peuvent être stockés dans un registre de sortie 320 du décodeur ECC, et mis à disposition du système électronique 310.

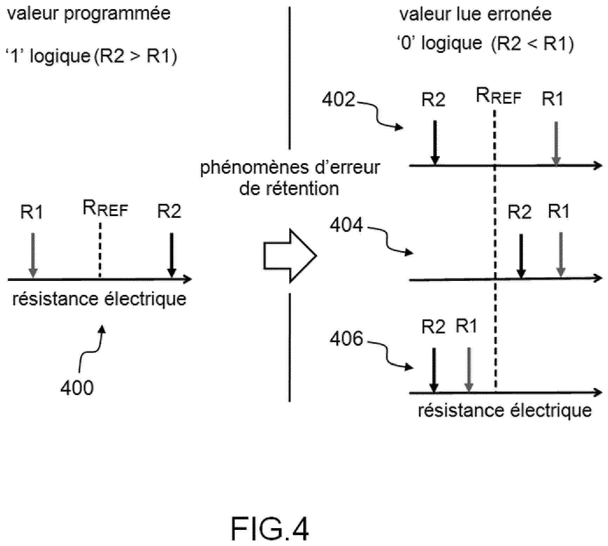

Comme expliqué précédemment, les valeurs de résistance de chaque élément résistif d'une cellule élémentaire 2T2R peuvent dériver dans le temps. La figure 4 illustre des dérives possibles des valeurs des deux résistances R1 et R2 d'une cellule mémoire 2T2R.

Pour expliquer ces dérives, on peut prendre pour hypothèse qu'un '1' logique est stocké dans une cellule 2T2R, en programmant la première résistance R1 à un état à faible résistance (LRS) et en programmant la deuxième résistance R2 à un état à haute résistance (HRS), tel que « R2 > R1 ».

Lors d'une opération d'écriture en mémoire, les résistances R1 et R2 qui ont été programmées doivent être vérifiées chacune en mode 1T1R par rapport à une valeur de référence (R_{REF}).

Selon la programmation indiquée, la lecture 1T1R de la première cellule doit retourner que la valeur lue est inférieure à la valeur de référence « R1 < R_{REF} », et la lecture 1T1R de la deuxième cellule doit retourner que la valeur lue est supérieure à la valeur de référence « R2 > R_{REF} », tel qu'illustré par la référence 400.

Avec l'augmentation du temps de stockage, les valeurs des résistances R1 et de R2 peuvent dériver de telle sorte que la condition « R2 > R1 « n'est plus valide. Il peut alors, pour une opération de lecture en différentiel dans la mémoire 2T2R, être détecté un '0' logique qui est incorrect, au lieu du '1' logique initialement programmé.

La partie de droite de la figure 4, montre trois scénarios possibles selon lesquels la condition R2 > R1 devient invalide. Dans le premier scénario 402, les résistances R1 et R2 ont dérivé de telle sorte que « R2 < R1 » avec « R1 > R_{REF} » et « R2 < R_{REF} », c'est-à-dire que les deux résistances sont positionnées de part et d'autre de la valeur de référence.

Dans le deuxième scénario 404, les résistances R1 et R2 ont dérivé de telle sorte que « R2 < R1 » mais avec « R1 > R_{REF} » et « R2 > R_{REF} », c'est-à-dire que les deux résistances sont plus grandes que la valeur de référence.

Dans le troisième scénario 406, les résistances R1 et R2 ont dérivé de telle sorte que « R2 < R1 » mais avec « R1 < R_{REF} » et « R2 < R_{REF} », c'est-à-dire que les deux résistances sont plus petites que la valeur de référence.

Selon le procédé de l'invention, les cas de dérive illustrés par le deuxième et le troisième scénarios vont être identifiés pour améliorer la correction d'erreurs. En effet, en identifiant que les valeurs des deux résistances R1 et R2 d'une même cellule 2T2R sont « positionnées » du même côté que la valeur de référence, indique qu'au moins une de ces résistances R1 ou R2 a été soumises à une dérive significative, voire les deux résistances ont pu dériver), et dès lors cela peut induire une opération de lecture 2T2R erronée.

Ainsi, le principe général de l'invention consiste à identifier des bits pour lesquels une ou les deux valeurs de résistances ont dérivé de telle sorte que les deux valeurs sont soit supérieures, soit inférieures à une valeur de référence. De telles situations n'indiquent pas nécessairement que les bits qui ont été programmés vont être détectés en erreur lors d'une lecture en mode différentiel, mais leur identification indique qu'ils sont susceptibles d'être erronés. Ces bits sont considérés comme étant des bits faibles et sont désignés comme étant des « erasures ».

L'identification des erasures, est faite par le procédé de l'invention en effectuant dans un mode de réalisation, au moins une lecture en mode 1T1R sur une des deux cellules 1T1R d'une cellule élémentaire 2T2R. La lecture 1T1R permet de comparer à une valeur de référence, la valeur d'un des deux éléments résistifs de la cellule élémentaire qui est adressée, et déterminer si la valeur lue a dérivé par rapport à la valeur de référence.

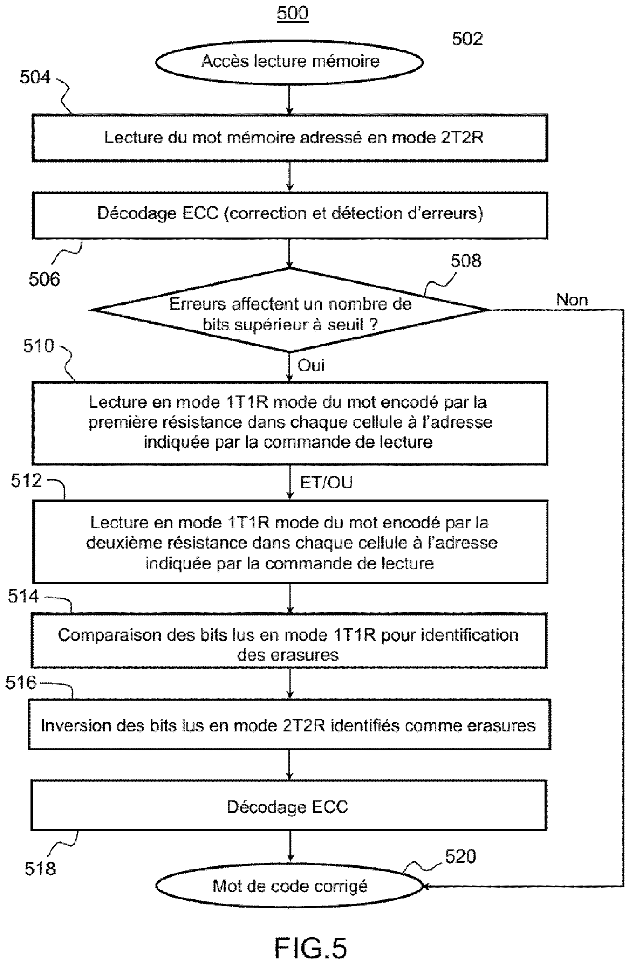

La figure 5 illustre les étapes du procédé de correction d'erreurs de l'invention dans un mode de réalisation. Le procédé 500 opéré pour une mémoire 2T2R protégée par un ECC, permet d'améliorer la correction d'erreurs en identifiant des erasures.

Les premières étapes du procédé sont identiques à celles d'un procédé conventionnel, tel que décrit en référence à la figure 2, à savoir une étape 502 d'accès à une adresse de la mémoire 2T2R stockant un mot de code, une étape 504 de lecture du mot de code stocké à l'adresse lue, et une étape 506 de mise en oeuvre d'un mécanisme de correction et détection d'erreurs par un ECC couplé à la mémoire.

Dans une étape suivante 508, le procédé permet de vérifier si le décodeur ECC indique la présence d'erreurs qui affectent un nombre de bits supérieur à un seuil prédéfini.

Dans un mode de réalisation, la valeur du seuil est fixée telle que le nombre de bits affectés par une erreur ne dépasse pas le nombre maximum de bits erronés qui sont corrigeables par le décodeur ECC qui est utilisé ce qui est équivalent au fait de déterminer que ledit nombre de bits affectés est égal au nombre maximum de bits erronés que le décodeur ECC peut détecter dans un mot de code.

Si le nombre de bits affectés reste inférieur au seuil (branche Non de 508), le procédé se termine de manière conventionnelle par l'étape 520 avec la fourniture d'un mot de code corrigé uniquement par l'ECC utilisé de façon conventionnelle.

Si le nombre de bits affectés est supérieur au seuil prédéfini (branche Oui de 508), le procédé continue avec un mécanisme d'identification d'erasures et de correction de bits erronés.

Dans un mode de réalisation, le procédé comprend avant l'étape de décodage 506, une étape consistant à stocker la valeur de chaque bit du mot de code lu en mode 2T2R dans un registre couplé à la mémoire résistive.

Dans un mode de réalisation, le procédé permet d'effectuer au moins une lecture 1T1R (étape 510 ou 512) dans chaque cellule élémentaire 2T2R adressée, qui consiste à comparer la valeur d'un des deux éléments résistifs des cellules élémentaires 2T2R adressées à une valeur de référence 'R_{ERASURE}', afin de déterminer la valeur lue.

Dans un mode de réalisation (étape 510), une lecture 1T1R se fait à l'adresse indiquée par la commande de lecture, sur les éléments résistifs de chaque cellule élémentaire 2T2R encodant les valeurs inversées des bits.

Dans un autre mode de réalisation (étape 512), une lecture 1T1R se fait à l'adresse indiquée par la commande de lecture, sur les éléments résistifs de chaque cellule élémentaire 2T2R encodant les valeurs non-inversées des bits.

Le procédé se poursuit par une étape 514 de comparaison des bits lus en lecture 1T1R (étape 510 ou 512) aux bits lus en lecture 2T2R (étape 504).

La comparaison se fait pour chaque bit du mot de code stocké à l'adresse lue, pour identifier des bits susceptibles d'être erronés, lesdits bits susceptibles d'être erronés étant :
- des bits pour lesquels la valeur lue en lecture 1T1R est identique à la valeur lue en lecture 2T2R, si la lecture 1T1R se fait sur les éléments résistifs de la cellule élémentaire encodant les valeurs inversées des bits ; ou
- des bits pour lesquels la valeur lue en lecture 1T1R est différente de la valeur lue en lecture 2T2R, si la lecture 1T1R se fait sur les éléments résistifs de la cellule élémentaire encodant les valeurs non-inversées des bits.

Dans un mode de réalisation, l'étape 514 de comparaison comprend des étapes consistant à :
- stocker la valeur de chaque bit lu en mode 1T1R dans un registre couplé à la mémoire résistive ; et
- comparer la valeur de chaque bit stocké, à la valeur de chaque bit du mot de code lu en mode 2T2R.

Après l'étape 514 d'identification d'erasures, le procédé poursuit par une étape 516 qui consiste à inverser dans le mot de code corrigé lesdits bits identifiés comme susceptibles d'être erronés, puis une étape 518 de correction et détection d'erreurs par l'ECC, afin de générer 520 un nouveau mot de code corrigé.

Dans un mode de réalisation où la comparaison des valeurs lues en mode 1T1R avec les valeurs lues en mode 2T2R n'identifie pas un nombre d'erasures suffisant pour débloquer le décodage ECC, le procédé permet une lecture en mode 1T1R de l'autre résistance utilisée pour l'encodage en mode 2T2R.

Ainsi, dans un mode de réalisation, l'étape d'effectuer au moins une lecture 1T1R, peut consister à effectuer une première lecture 1T1R (étape 510) de chaque premier élément résistif des cellules élémentaires adressées, afin de déterminer une première valeur lue et à effectuer une deuxième lecture 1T1R (étape 512) de chaque deuxième élément résistif des cellules élémentaires adressées, afin de déterminer une deuxième valeur lue.

Dans ce mode de réalisation, les deux résistances électriques d'une cellule 2T2R sont considérées avoir été programmées afin qu'une soit plus petite et l'autre plus grande qu'une valeur de référence R_{REF} (utilisée lors d'une opération préalable d'écriture mémoire). Par conséquent, en comparant, lors des deux opérations de lecture en mode 1T1R, chaque valeur de résistance électrique à une même valeur de référence R_{ERASURE}, des valeurs logiques opposées doivent être lues dans chaque cellule 2T2R adressée pendant les étapes de lecture 510 et 512.

Dans ce mode de réalisation à double lecture 1T1R, l'étape de comparaison pour identifier des bits susceptibles d'être erronés consiste à comparer la première valeur lue en mode 1T1R à la deuxième valeur lue en mode 1T1R. L'identification des bits susceptibles d'être erronés consiste à déterminer les bits pour lesquels la première valeur lue en lecture 1T1R et la deuxième valeur lue en lecture 1T1R sont identiques. En effet, dans le cas où pour une cellule 2T2R, les deux valeurs lues en lecture 1T1R sont identiques, il peut être considéré qu'au moins une des deux résistances électriques a fait l'objet d'une dérive importante depuis sa programmation dans un état de faible résistance ou un état de haute résistance. Par conséquent, le bit lu en mode 2T2R à partir de ces deux résistances a pu être évalué de façon erronée et il peut alors être considéré comme une erasure.

Après la double lecture 1T1R et identification des bits erasures, le procédé se poursuit par les étapes 516 d'inversion de bits dans le mot de code lu en 2T2R, de décodage 518 par l'ECC et d'obtention 520 d'un mot de code corrigé.

Les bits des données du nouveau mot de code corrigé peuvent être mis à la disposition du système électronique 310 qui a lancé la commande de lecture.

Dans un mode de réalisation, l'étape 518 de corriger le mot de code obtenu après inversion, comprend des étapes consistant à :
- stocker la valeur de chaque bit dudit mot de code obtenu après inversion dans un registre couplé à la mémoire résistive ;
- corriger par le code correcteur d'erreur ledit mot de code stocké ; et
- stocker le mot de code corrigé dans le registre de sortie du décodeur ECC.

Dans le cas où l'encodeur ECC indique toujours une erreur non-corrigeable le contrôleur mémoire peut signaler une erreur de lecture au système électronique.

De manière avantageuse, la valeur de référence R_{ERASURE} utilisée pendant la ou les opérations de lecture en mode 1T1R est identique à la valeur de référence R_{REF} utilisée pendant une opération de programmation dans une mémoire 2T2R (qui est faite pour s'assurer que les résistances électriques sont bien programmées à LRS ou HRS).

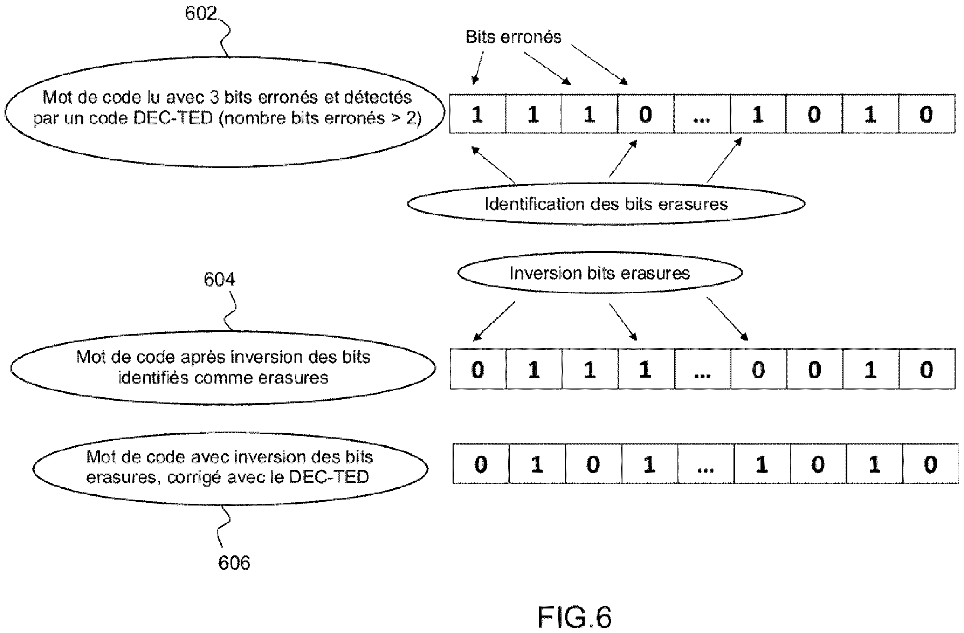

La figure 6 illustre un exemple d'un mot de code corrigé par le procédé de l'invention.

Sur la partie haute de la figure, un mot 602 d'un code DEC-TED (permettant la correction des erreurs simples et doubles et la détection des erreurs triples) est lu avec trois bits erronés. Dans l'exemple, le mot de code (1, 1, 1, 0, ..., 1, 0, 1, 0) indique que le premier '1', le troisième `1' et le quatrième '0' bit sont erronés. Le décodeur DEC-TED permet de détecter la présence des trois bits erronés mais pas leur position. Le nombre d'erreurs '3' est dans cet exemple plus grand que le seuil égal à `2' permis par le DEC-TED afin de pouvoir les corriger.

Les étapes (510, 512, 514) du procédé de l'invention permettent d'identifier dans le mot de code 602 des erasures, i.e. le premier bit '1', le quatrième bit '0' et le nième bit '1'.

L'étape 516 du procédé de l'invention permet d'inverser les bits erasures, et le mot de code 604 devient (0, 1, 1, 1, ..., 0, 0, 1, 0).

Les étapes 518 et 520 du procédé de l'invention permettent de corriger le mot de code 604 et obtenir un nouveau mot de code 606 corrigé (0, 1, 0, 1, ..., 1, 0, 1, 0) qui dans cet exemple ne contient plus aucun bit erroné.

Les inventeurs ont constaté que pour des mots de code avec 32 bits de données, l'utilisation d'un ECC de type SEC-DED au lieu d'un DEC, et l'utilisation d'un ECC de type DEC-TED au lieu d'un TEC, permet de réduire le nombre de bits de vérification par mot de code respectivement de 42% et de 28%.

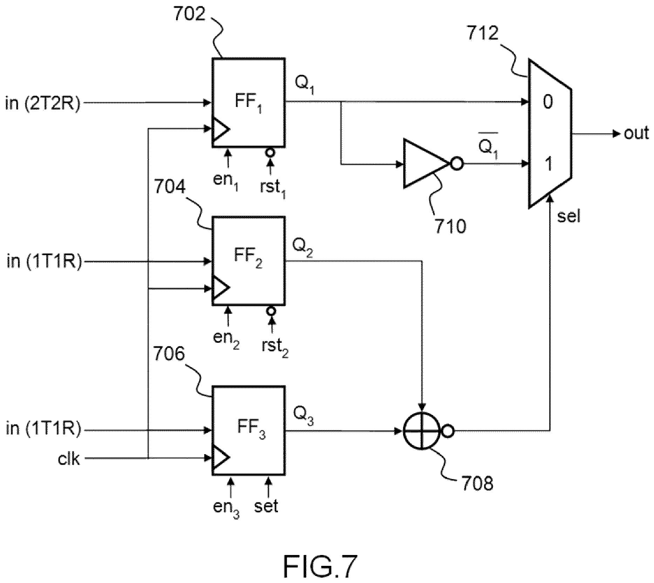

La figure 7 illustre un mode de réalisation d'un circuit 700 permettant de réaliser une inversion de bits lus en mode 2T2R et identifiés comme erasures à travers la comparaison des deux valeurs lues en mode 1T1R. Le circuit 700 peut être utilisé pour remplacer chaque bascule d'un registre de sortie de la mémoire 2T2R, par exemple le registre de sortie 340 de la figure 3.

Le circuit d'inversion de bits comprend principalement trois bascules synchrones (702, 704, 706). Une première bascule 702 peut recevoir sur son entrée in(2T2R) un bit lu en mode 2T2R dans la mémoire correspondant à l'étape 504 , une deuxième bascule 704 peut recevoir sur son entrée in(1T1R) l'un des bits lu en mode 1T1R correspondant à l'étape 510, et une troisième bascule 706 peut recevoir sur son entrée in(1T1R) l'autre bit lue en mode 1T1R correspondant à l'étape 512.

Les bascules sont cadencées par un signal d'horloge `clk', et être initialisées par des signaux de 'set' et 'reset' (respectivement 'rst₁' pour la première bascule 702, 'rst₂' pour la deuxième bascule 704, et `set' pour la troisième bascule 706). Chaque bascule est contrôlée par un signal 'en' généré par un contrôleur mémoire, respectivement 'en₁' pour la première bascule 702, 'en₂' pour la deuxième bascule 704, 'en₃' pour la troisième bascule 706.

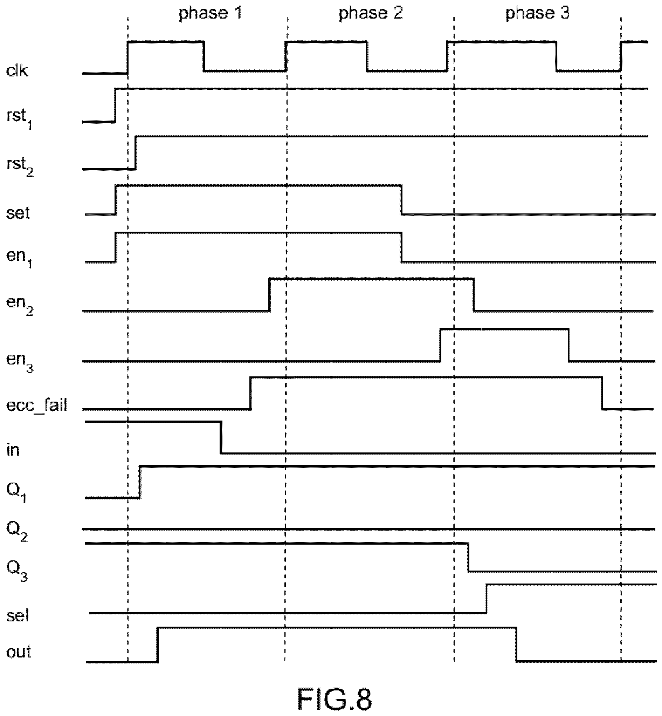

La figure 8 présente un chronogramme des différents signaux opérant sur le circuit de la figure 7.

La sortie Q₁ de la première bascule 702 est couplée d'une part à une première entrée d'un multiplexeur 712, et d'autre part à l'entrée d'un inverseur 710 qui est utilisé pour fournir une version inversée du bit stocké dans la première bascule 702. La sortie *Q̅₁̅*de l'inverseur 710 devient la deuxième entrée du multiplexeur 712.

Les sorties Q₂ et Q₃ des deuxièmes et troisièmes bascules 704 et 706 deviennent les entrées d'une porte logique XNOR 708. La sortie de la porte logique XNOR 708 devient un signal de sélection 'sel' pour le multiplexeur 712. La valeur en sortie de la porte logique XNOR 708 est un '1' logique seulement quand ses deux entrées sont identiques, i.e. correspondant aux bits respectivement stockés dans la deuxième et la troisième bascule 704 et 706.

Le multiplexeur 712 permet de sélectionner et délivrer un signal 'out' correspondant à la valeur inversée ou à la valeur non-inversée du bit stocké dans la première bascule 702, en fonction de la valeur logique fournie par la porte XNOR 708, et donc de la valeur du signal de sélection 'sel'.

Dans ce mode de réalisation, la deuxième bascule 704 et la troisième bascule 706 sont initialisées à des valeurs différentes au début de chaque accès à la mémoire 2T2R.

Dans une variante de réalisation du circuit d'inversion, les bascules 702, 704 et 706 peuvent être remplacées par des verrous.

L'homme du métier pourra considérer d'autres variantes d'implémentation différentes du circuit d'inversion.

Pour chacun des signaux représentés sur le chronogramme de la figure 8, il est considéré qu'une valeur élevée ou basse représente respectivement un '1' ou un '0' logique.

La première bascule 702 et la deuxième bascule 704 peuvent être initialisées à 0 si le signal 'rst₁', respectivement 'rst₂', présente la valeur 0 pendant le front montant du signal d'horloge 'clk'. La troisième bascule 706 peut être initialisée à 1 si le signal `set' est égal à 1 pendant le front montant du signal d'horloge `clk'.

Dans le cas contraire, chacune de ces trois bascules peut changer son état en fonction du signal d'entrée 'in' seulement si son signal de contrôle 'en' est égal à '1' pendant le front montant du signal d'horloge `clk'.

Sur le chronogramme de la figure 8, une première phase 'phase 1' reflète la lecture de la première bascule (le signal 'en₁' égal à '1' pendant le front montant du signal `clk'), dont la sortie Q₁ devient '1' logique. Lorsque le signal 'ecc_fail' fourni par le décodeur ECC indique la présence d'une erreur non-corrigeable, les phases 2 et 3 (i.e. correspondant à la mise en oeuvre des étapes 510 à 514) sont exécutées. Dans l'exemple du chronogramme de la figure 8, le signal 'ecc_fail' passe à '1' pour refléter que le résultat de l'étape 508 indique qu'il reste des erreurs qui affectent un nombre de bits supérieur au seuil prédéfini.

Durant la phase 2, la lecture en mode 1T1R (le signal 'en₂' égal à '1' pendant le front montant du signal 'clk') fournit la valeur de la sortie Q₂ de la deuxième bascule 704, qui est un '0' logique.

Durant la phase 3, la lecture en mode 1T1R (le signal 'en₃' égal à '1' pendant le front montant du signal 'clk') fournit la valeur de la sortie Q₃ de la troisième bascule 706, qui est un '0' logique.

Sur cet exemple, le bit lu en mode différentiel est égal à '1' et les deux bits lus en mode 1T1R sont égaux à '0', ce qui indique que le bit lu en mode différentiel peut être identifié comme erasure.

La dernière ligne du chronogramme reflète la valeur du signal de sortie 'out' qui bascule pour inverser la valeur du bit identifié comme erasure.

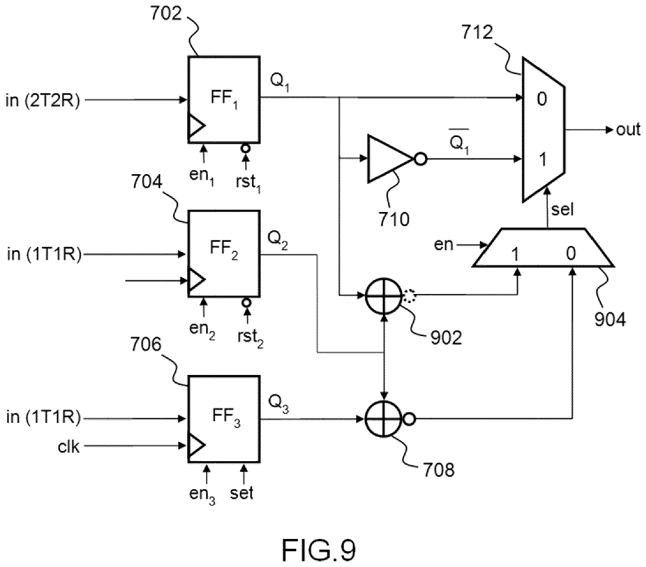

La figure 9 illustre un autre mode de réalisation d'un circuit 900 permettant de réaliser une inversion de bits identifiés comme erasures selon le procédé de l'invention. Les éléments en commun avec le circuit présenté en figure 7 conservent les mêmes références et ne sont pas décrits de nouveau. Comme pour le circuit 700 de la figure 7, ce dispositif 900 d'inversion de bits erasure vient en remplacement de chaque bascule conventionnelle dans le registre de sortie 340 de la mémoire résistive.

Dans cette variante de réalisation, le circuit comprend une deuxième porte logique XNOR 902 et un deuxième multiplexeur 904 en plus. La deuxième porte logique XNOR 902 prend en entrée la sortie de la première bascule 702, et la sortie de la deuxième bascule 704 pour les comparer. Le deuxième multiplexeur 904 prend en entrée la sortie de la première porte XNOR 708 et la sortie de la deuxième porte XNOR 902, pour délivrer un signal de sélection 'sel' vers le premier multiplexeur 712, lorsqu'il est activé par un signal de contrôle 'en'.

En fonctionnement, il est par exemple considéré que la première valeur lue en mode 1T1R est stockée dans la deuxième bascule 704 et que cette valeur est comparée à la valeur lue en mode 2T2R qui est stockée dans la première bascule 702. Dans le cas où la première valeur lue en mode 1T1R a été programmée de façon à encoder la version inversée des bits programmés dans la cellule 2T2R alors la porte logique qui fait la comparaison doit être une porte de type XNOR, comme sur l'exemple de la figure 9.

De manière similaire, dans le cas où la première valeur lue en mode 1T1R a été programmée de façon à encoder la version non-inversée des bits programmés dans la cellule 2T2R alors la porte logique qui fait la comparaison doit être une porte de type XOR (non illustré).

Le deuxième multiplexeur 904 est piloté par un signal 'en' généré par le contrôleur mémoire. Dans ce mode de réalisation, il peut être prévu d'avoir le signal 'en' égal à un '1' logique seulement pendant le cycle où les valeurs de la première 702 et de la deuxième bascule 704 sont comparées.

La présente description illustre une implémentation préférentielle de l'invention, mais qui n'est pas limitative. Des exemples sont choisis pour permettre une bonne compréhension des principes de l'invention et une application concrète, mais ne sont en rien exhaustifs et doivent permettre à l'homme du métier d'apporter des modifications et des variantes d'implémentation aux différents circuits en conservant les mêmes principes. Dans des variantes de réalisation, chaque module fonctionnel d'encodage, de comptage, de comparaison et d'inversion peut être implémenté par un module dédié tel qu'un ASIC.

L'invention peut s'implémenter à partir d'éléments matériels et/ou logiciels. Elle peut être disponible en tant que produit programme d'ordinateur exécuté par un processeur dédié ou par un contrôleur mémoire d'un système de stockage, et qui comprend des instructions de code pour exécuter les étapes des procédés dans leurs différents modes de réalisation.

## Revendications

1. Procédé de correction d'erreurs d'un mot de code stocké dans une mémoire résistive de type 2T2R, un mot de code étant composé de bits de données et de bits de vérification, la mémoire résistive 2T2R comprenant une matrice de cellules mémoires résistives 2T2R élémentaires où chaque cellule élémentaire comprend deux transistors et deux éléments résistifs pour stocker la valeur non-inversée et la valeur inversée d'un bit, et pour lire les bits stockés en mode différentiel, la lecture en mode différentiel ou lecture 2T2R consistant à comparer l'une par rapport à l'autre, les valeurs du premier et deuxième élément résistif de la cellule élémentaire utilisée pour stocker chaque bit d'un mot à une adresse indiquée, afin de déterminer la valeur lue, le procédé de correction d'erreurs comprenant au moins les étapes suivantes :
- déterminer, après une opération de correction d'erreurs par un code correcteur d'erreur couplé à la mémoire résistive, qu'un mot de code lu en lecture 2T2R contient des erreurs non corrigées qui affectent un nombre de bits supérieur à un seuil prédéfini ;
- effectuer au moins une lecture en mode simple ou lecture 1T1R du mot de code stocké, consistant à comparer à une valeur de référence R_{ERASURE}, la valeur d'un des deux éléments résistifs des cellules élémentaires adressées pour chaque bit du mot de code, afin de déterminer la valeur lue ;
- comparer pour chaque bit du mot de code, la valeur lue par la dite au moins une lecture 1T1R à la valeur lue en lecture 2T2R pour identifier des bits susceptibles d'être erronés, lesdits bits susceptibles d'être erronés étant :
- des bits pour lesquels la valeur lue en lecture 1T1R est identique à la valeur lue en lecture 2T2R, si ladite au moins une lecture 1T1R se fait sur les éléments résistifs de la cellule élémentaire encodant les valeurs inversées des bits ; ou
- des bits pour lesquels la valeur lue en lecture 1T1R est différente de la valeur lue en lecture 2T2R, si ladite au moins une lecture 1T1R se fait sur les éléments résistifs de la cellule élémentaire encodant les valeurs non-inversées des bits ;
- inverser, dans ledit mot de code lu en lecture 2T2R, lesdits bits identifiés comme susceptibles d'être erronés ; et
- corriger avec le code correcteur d'erreur ledit mot de code obtenu après l'étape d'inversion.

2. Procédé selon la revendication 1 dans lequel, l'étape de déterminer qu'un mot de code contient des erreurs non corrigées qui affecte un nombre de bits supérieur à un seuil prédéfini, consiste à déterminer que ledit nombre de bits affectés est égal au nombre maximum de bits erronés que le décodeur du code correcteur d'erreur peut détecter dans un mot de code.

3. Procédé selon la revendication 1 ou 2, dans lequel les étapes de lecture 1T1R et de comparaison de valeur lue, consistent à:
- effectuer une première lecture 1T1R de chaque premier élément résistif des cellules élémentaires adressées pour chaque bit du mot de code, afin de déterminer une première valeur lue ;
- effectuer une deuxième lecture 1T1R de chaque deuxième élément résistif des cellules élémentaires adressées pour chaque bit du mot de code, afin de déterminer une deuxième valeur lue ;
et
- comparer la première valeur lue en mode 1T1R à la deuxième valeur lue en mode 1T1R, pour identifier des bits susceptibles d'être erronés comme étant des bits pour lesquels la première valeur lue et la deuxième valeur lue sont identiques.

4. Procédé selon l'une quelconque des revendications 1 à 3 comprenant avant l'étape de détermination, une étape consistant à stocker la valeur de chaque bit du mot de code lu en mode 2T2R dans un registre couplé à la mémoire résistive.

5. Procédé selon l'une quelconque des revendications 1 à 4 dans lequel l'étape de corriger le mot de code obtenu après inversion, comprend des étapes consistant à :
- stocker la valeur de chaque bit dudit mot de code obtenu après inversion dans un registre couplé à la mémoire résistive ;
- corriger par le code correcteur d'erreur ledit mot de code stocké ; et
- stocker le mot de code corrigé dans le registre de sortie du décodeur du code correcteur d'erreur.

6. Procédé selon l'une quelconque des revendications 1 à 5, dans lequel l'étape de comparaison comprend des étapes consistant à :
- stocker la valeur de chaque bit lu en mode 1T1R dans un registre couplé à la mémoire résistive ; et
- comparer la valeur de chaque bit stocké à la valeur de chaque bit du mot de code lu en mode 2T2R.

7. Le procédé selon l'une quelconque des revendications 1 à 6 dans lequel l'étape d'effectuer au moins une lecture en mode 1T1R consiste à comparer la valeur lue à une valeur de référence R_{ERASURE} qui peut être identique à la valeur de référence utilisée pour programmer les cellules élémentaires de la mémoire résistive.

8. Un dispositif de correction d'erreurs d'un mot de code stocké dans une mémoire résistive de type 2T2R, un mot de code étant composé de bits de données et de bits de vérification, la mémoire résistive 2T2R comprenant une matrice de cellules mémoires résistives 2T2R élémentaires où chaque cellule élémentaire comprend deux transistors et deux éléments résistifs pour stocker la valeur non-inversée et la valeur inversée d'un bit, et pour lire les bits stockés en mode différentiel, la lecture en mode différentiel ou lecture 2T2R consistant à comparer l'une par rapport à l'autre, les valeurs du premier et deuxième élément résistif de la cellule élémentaire utilisée pour stocker chaque bit d'un mot à une adresse indiquée, afin de déterminer la valeur lue, le dispositif comprenant des moyens permettant de mettre en oeuvre les étapes du procédé selon l'une quelconque des revendications 1 à 7.

9. Le dispositif selon la revendication 8 dans lequel le code correcteur d'erreur est un circuit de type SEC-DED ou DEC-TED.

10. Le dispositif selon la revendication 8 ou 9 dans lequel la mémoire résistive est choisie dans le groupe des mémoires résistives à pont conducteur CBRAM, des mémoires résistives à base d'oxyde OxRAM, ou des mémoires résistives à changement de phase PCM.

11. Un système électronique de type FPGA ou ASIC comprenant un dispositif selon l'une quelconque des revendications 8 à 10.

12. Programme d'ordinateur comportant des instructions de code pour l'exécution des étapes du procédé selon l'une quelconque des revendications 1 à 7, lorsque ledit programme est exécuté par un processeur.
